# EUROPÄISCHE PATENTANMELDUNG

(11) **EP 4 060 225 A1**
(43) Veröffentlichungstag der Anmeldung: **21.09.2022**
(21) Anmeldenummer: 22162607.0
(22) Anmeldetag: 17.03.2022
(51) Int. Cl.: F21V 8/00, F21W 131/20, F21Y 105/18, F21Y 113/10, F21Y 115/10

(54) **LEUCHTE**

(30) Priorität: 18.03.2021 DE 102021106609
(71) Anmelder: Bartenbach Holding GmbH, 6071 Aldrans (AT)
(72) Erfinder: Anselm, Christian, 6112 Wattens (AT); Debbage, Roy, 6175 Kematen in Tirol (AT); Reisecker, Christian, 6166 Fulpmes (AT); SPIELBERGER, Georg, 6020 Innsbruck (AT); TANLER, Peter, 6071 Aldrans (AT)
(74) Vertreter: Thoma, Michael

(57) **Zusammenfassung**

Die vorliegende Erfindung betrifft eine Leuchte mit mehreren Lichtquellen (2) sowie einer Mischoptik (3) zum Durchmischen des von den Lichtquellen (2) abgegebenen Lichts, die zumindest einen Lichtmischstab (4) aufweist, der mehrere Lichteintrittsflächen (8) aufweist, die in Längsrichtung des Lichtmischstabs (4) voneinander beabstandet angeordnet sind, wobei die mehreren Lichtquellen (2) auf die mehreren Lichteintrittsflächen (8) verteilt und in Längsrichtung des Lichtmischstabs (4) zueinander versetzt angeordnet sind, der Lichtmischstab (4) an seinem Lichteintrittsende (5) zumindest einen säulenartigen Vorsprung (10) besitzt, der eine kleinere Querschnittsfläche als ein Mittelabschnitt (4m) des Lichmischstabs (4) besitzt und mit seinem stirnseitigen Ende eine der Lichteintrittsflächen (8a) bildet, wobei sich am Wurzelbereich des säulenartigen Vorsprungs (10) zumindest eine zweite Lichteintrittsfläche (8b) spaltfrei und/oder bündig anschließt.

## Beschreibung

Die vorliegende Erfindung betrifft eine Leuchte mit mehreren Lichtquellen sowie einer Mischoptik zum Durchmischen des von den Lichtquellen abgegebenen Lichts, die zumindest einen Lichtmischstab aufweist.

In vielen Beleuchtungsanwendungen werden heutzutage LEDs als Lichtquellen verwendet, wobei es aus verschiedensten Gründen gewünscht und sinnvoll ist, mehrere LEDs zu verwenden, die üblicherweise in einem Cluster eng nebeneinanderliegend angeordnet werden. Beispielsweise werden kalt- und warmweiße LEDs in Clustern angeordnet und deren Licht gemischt, um eine verstellbare Farbtemperatur bzw. das sogenannte "tunable white" zu ermöglichen. Von der Farbeinstellung abgesehen werden in diversen Spezialanwendungen auch recht spezielle LEDs zusammen verwendet bzw. in Clustern angeordnet. Beispielsweise im Medizinbereich werden für Spezialanwendungen wie z.B. eine UV-Licht-Desinfektion, Narrow Band Imaging oder Fluoreszenzbeleuchtungen spezielle LEDs wie UV-, IR- oder schmalbandige Farb-LEDs miteinander gemischt oder zu dem Licht einer beispielsweise weißen Basis-LED dazugemischt. Auch für die Erzielung hoher Lichtstärken kann es hilfreich sein, mehrere Lichtquellen zu verwenden.

Um zu vermeiden, dass sich die mehreren Lichtquellen über die Optik der Leuchte im Beleuchtungsfeld abzeichnen und zu Farbabbildungen führen, wird das Licht aus den verschiedenen Lichtquellen durch eine Mischoptik durchmischt, wobei oft ein Mischstab über das Lichtquellen- bzw. LED-Cluster gesetzt wird, der das Licht dann in eine ggf. nachgeschaltete Optik einkoppelt. Solche Lichtmischstäbe sind in diversen Ausführungen bekannt, vgl. beispielsweise US 10,330,293 B2 oder US 10,495,802 B2.

Insbesondere bei sehr kleinen Leuchten, deren Abmessungen starken Restriktionen unterliegen, wie beispielsweise bei chirurgischen oder anderen medizinischen Anwendungen, fällt naturgemäß auch der Lichtmischstab sehr klein aus, sodass es schwierig ist, die LEDs bzw. Lichtquellen in ausreichender Anzahl an der Lichteintrittsfläche des Mischstabs anzuordnen. Hierbei kommt erschwerend hinzu, dass die Lichtquellen oft lichttechnisch inaktive Abschnitte bzw. Teile besitzen, die eine dichte, nahezu lückenlose Packung der lichttechnisch aktiven Teile weiter behindern. Bei LEDs sitzt der lichtemittierende Chip üblicherweise auf einem Package, das je nach LED-Typ randseitig über den Chip überstehen kann, sodass in einem LED-Cluster die Chips um die randseitigen Überstände voneinander beabstandet sind.

Es wurde insofern schon angedacht, mit mehreren Leuchten zu arbeiten bzw. in eine Leuchte mehrere Mischoptiken mit mehreren Mischstäben zu integrieren. Wenn allerdings das Licht von verschiedenen Optiken herkommend in ein Zielgebiet geworfen wird, kommt es im Zielgebiet zu Schatten, beispielsweise Farbschatten, wenn verschiedenfarbiges Licht über verschiedene Optiken kommt.

Hiervon ausgehend liegt der vorliegenden Erfindung die Aufgabe zugrunde, eine verbesserte Leuchte der genannten Art zu schaffen, die Nachteile des Standes der Technik vermeidet und letzteren in vorteilhafter Weise weiterbildet. Insbesondere soll auch bei kleinen und kleinsten Abmessungen der Leuchte eine ausreichende Zahl von Lichtquellen verwendet und deren Licht gleichmäßig durchmischt werden können, um eine gleichmäßige Ausleuchtung des Zielgebiets ohne Schattenbildung zu ermöglichen.

Erfindungsgemäß wird die genannte Aufgabe durch eine Leuchte gemäß Anspruch 1 gelöst. Bevorzugte Ausgestaltungen der Erfindung sind Gegenstand der abhängigen Ansprüche.

Um eine Kollision der Lichtquellen miteinander in einer clusterartigen Anwendung zu vermeiden, werden die Lichtquellen axial in Längsrichtung des Mischstabs zueinander versetzt angeordnet und die Lichteintrittsfläche in mehrere Teilflächen aufgespaltet, die übereinandergestapelt angeordnet sind, um den axial versetzten Lichtquellen die Einkoppelung zu ermöglichen.

Erfindungsgemäß besitzt der Lichtmischstab mehrere Lichteintrittsflächen, die in Längsrichtung des Lichtmischstabs zueinander versetzt angeordnet sind, wobei die mehreren Lichtquellen auf die mehreren Lichteintrittsflächen verteilt und axial zueinander in Längsrichtung des Lichtmischstabs versetzt angeordnet sind. Dabei besitzt der Lichtmischstab an seinem Lichteintrittsende zumindest einen säulenartigen Vorsprung, der eine kleinere Querschnittsfläche als einen Mittelabschnitt des Mischstabs besitzt und mit seinem stirnseitigen Ende eine der Lichteintrittsflächen bildet, wobei sich am Wurzelbereich des säulenartigen Vorsprungs zumindest eine zweite Lichteintrittsfläche spaltfrei und/oder bündig anschließt.

Durch die axial versetzte Anordnung haben die Lichtquellen quer voneinander ausreichend Luft, um auch bei dichter, geclusterter Anordnung nicht miteinander zu kollidieren. Gleichzeitig wird durch die ebenfalls axial versetzten Lichteintrittsflächen eine effiziente Einkoppelung des Lichts aus den verschiedenen Lichtquellen in den gemeinsamen Lichtmischstab ermöglicht.

In vorteilhafter Weiterbildung der Erfindung kann der Lichtmischstab an seinem Lichteintrittsende terrassenartig abgestuft sein und zueinander in verschiedenen Höhen bzw. axial versetzt angeordnete Terrassenflächen umfassen, die die Lichteintrittsflächen des Lichtmischstabs bilden. Die terrassenartigen Abstufungen bilden mit ihren stirnseitigen Endflächen jeweils eine der genannten Lichteintrittsflächen, wobei die terrassierten Abstufungen bzw. die Stufenabschnitte des eintrittsseitigen Endabschnitts des Mischstabs integral einstückig, materialhomogen mit dem restlichen Korpus bzw. einem anschließenden Mittelabschnitt des Lichtmischstabs verbunden sein können. Das Lichteintrittsende kann sozusagen stufig aus dem Mittelkorpus des Mischstabs herauswachsen, um auf axial verschieden weit vorstehenden, stirnseitigen Endflächen ohne Kollisionsprobleme Lichtquellen positionieren zu können.

Alternativ zu einer integral einstückigen, materialhomogenen Ausbildung der terrassenartigen Vorsprünge könnten letztere aber auch separat ausgebildet und optisch dicht an den Korpus des Lichtmischstabs angesetzt sein.

Der genannte Korpus des Lichtmischstabs kann dabei ein Vollmaterialkorpus sein, wobei auch die terrassierten, endseitigen Vorsprünge bzw. Abstufungen jeweils Vollmaterialabschnitte bilden können, die schnittstellenfrei bzw. ohne störende Grenzflächen an den restlichen Korpus des Mischstabs anschließen können.

Der genannte säulenartige Vorsprung kann sich parallel zur Längsachse des Lichtmischstabs bzw. der Längsachse des Mittelabschnitts hiervon erstrecken. Unabhängig hiervon kann sich der säulenartige Vorsprung innerhalb einer Hüllfläche erstrecken, die den Mittelabschnitt des Lichtmischstabs einhüllt und axial zum Eintrittsende hin verlängert ist, sodass die Hüllfläche den besagten säulenartigen Vorsprung ebenfalls umschließt.

Der Lichtmischstab kann einen solchen säulenartigen Vorsprung umfassen, wobei aber auch mehrere solche säulenartigen Vorsprünge am lichteintrittsseitigen Ende des Lichtmischstabs vorgesehen sein können, wobei sich solche mehreren säulenartigen Vorsprünge zueinander parallel und/oder zur Längsachse des Mischstabs parallel erstrecken können.

Sind mehrere solche säulenartigen Vorsprünge vorgesehen, können die stirnseitigen Endflächen der Vorsprünge, die Lichteintrittsflächen bilden, in einer gemeinsamen Ebene angeordnet sein. Alternativ kann aber auch vorgesehen sein, dass die mehreren säulenartigen Vorsprünge unterschiedliche Längen besitzen und/oder mit ihren stirnseitigen, Lichteintrittsflächen bildenden Enden in Längsrichtung des Mischstabs zueinander versetzt angeordnet, insbesondere in parallelen, beabstandeten Ebenen angeordnet sind. Bei einer solchen orgelpfeifenartigen Anordnung der säulenartigen Vorsprünge können auch die den verschiedenen Vorsprüngen zugeordneten Lichtquellen axial versetzt zueinander angeordnet sein.

Der zumindest eine säulenartige Vorsprung kann mit seinem Wurzelbereich in verschiedenen Bereichen des anschließenden Mittelabschnitts des Mischstabs angeordnet sein. Beispielsweise kann ein säulenartiger Vorsprung in seinem Wurzelbereich, das heißt im Übergangsbereich zum axial anschließenden Mischstababschnitt, von einer ringförmigen Lichteintrittsfläche umgeben sein, auf der mehrere Lichtquellen vorgesehen sein können, die um den säulenartigen Vorsprung herum verteilt angeordnet sein können. Gegebenenfalls kann bei einer linearen Lichtquelle auch eine ringförmig gebogene Lichtquelle um den säulenartigen Vorsprung herum platziert sein.

Insbesondere kann ein säulenartiger Vorsprung zentral aus der Mitte des Lichtmischstabs hervorwachsen bzw. zum Lichteintrittsende hin vorspringen, wobei ggf. auch eine exzentrische Anordnung des säulenartigen Vorsprungs aus der Mitte des Mischstabs heraus versetzt vorgesehen sein kann.

Alternativ oder zusätzlich zu einem solchen inselartig angeordneten Vorsprung kann der Lichtmischstab an seinem Lichteintrittsende aber auch einen säulenartigen Vorsprung umfassen, der bündig an eine Umfangsfläche des benachbarten Mittelabschnitts des Mischstabs anschließt und im Wurzelbereich des Vorsprungs nur teilweise von einer dort vorgesehenen Lichteintrittsfläche des Mischstabs umgeben sein kann.

Beispielsweise können bei einem insgesamt rechteckigen Mischstab an den vier Ecken bzw. Kanten säulenartige Vorsprünge vorgesehen sein, zwischen deren Wurzelbereiche eine kreuzförmige Lichteintrittsfläche vorgesehen ist und die selbst an ihren stirnseitigen Enden vier Lichteintrittsflächen aufweisen. Allgemein können bei polygonal-konturierten Mischstäben an den Ecken bzw. Kanten jeweils säulenartige Vorsprünge angeordnet sein, wobei solche randseitig angeordneten Vorsprünge aber auch bei abgerundeten, beispielsweise kreisförmigen oder elliptischen Lichtmischstäben vorgesehen sein können.

Durch die Terrassierung bzw. den axialen Versatz der Lichteintrittsflächen können die den Lichteintrittsflächen zugeordneten Lichtquellen seitlichen Überstand haben und quer zur Längsachse des Lichtmischstabs über die Kontur der Lichteintrittsflächen überstehen, ohne dass dies zu einer Kollision bzw. erzwungenen weiteren Beabstandung der Lichtquellen führen würde. Insbesondere können lichttechnisch nicht aktive Abschnitte der Lichtquellen wie beispielsweise die randseitig über die LED-Chips überstehenden LED-Packages quer über die Lichteintrittsflächen vorspringend angeordnet sein, ohne dass dies die Einkoppelung des Lichts stören würde.

Insbesondere können die terrassierten Lichteintrittsflächen in ihren Abmessungen und Konturierungen an ein dicht gepacktes Cluster von Lichtquellen angepasst sein, insbesondere an deren geclusterten lichttechnisch aktiven Abschnitte, beispielsweise die geclusterten Chips mehrerer LEDs, ohne auf die seitlich überstehenden, lichttechnisch nicht aktiven Randabschnitte achten zu müssen. Die verschiedenen Lichteintrittsflächen können vorteilhafterweise im Wesentlichen vollständig mit lichttechnisch aktiven Lichtquellenabschnitten überdeckt sein, wenn der Lichtmischstab in einer Blickrichtung parallel zur Mischstablängsachse betrachtet wird.

Vorteilhafterweise können durch die Terrassierung der Lichteintrittsflächen Lichtquellen an den Lichteintrittsflächen angebracht werden, deren Querschnittsflächen bzw. Querausdehnungen - bei einer Blickrichtung parallel zur Mischstablängsachse - in Summe eine größere Gesamtfläche ergeben als die Summe der Lichteintrittsflächen. Trotzdem können die lichttechnisch aktiven Teile der Lichtquellen in kompletter Überdeckung mit den Lichteintrittsflächen angeordnet werden, obwohl die Summe der Flächen der Lichtquellenbausteine größer ist als die Summe der Lichteintrittsflächen und/oder als die Querschnittsfläche eines Mittelabschnitts des Lichtmischstabs.

Insbesondere können die terrassiert angeordneten Lichteintrittsflächen - bei Betrachtung in einer Blickrichtung parallel zur Mischstablängsachse - einander spalt- und überdeckungsfrei zu einer Gesamtfläche ergänzen, die kongruent zur Querschnittsfläche des gesamten Lichtmischstabs bzw. eines anschließenden Mittelabschnitts des Lichtmischstabs sein kann.

An den verschiedenen Lichteintrittsflächen des Mischstabs können Lichtquellen verschiedener Farbtemperatur und/oder verschiedenen Typs und/oder verschiedener Abmessungen angeordnet sein, wobei vorteilhafterweise an zumindest einer oder auch an jeder der Lichteintrittsflächen mehrere Lichtquellen gleichen Typs und/oder gleicher Lichtfarbe angeordnet sein können. Beispielsweise kann auf der Lichteintrittsfläche eines säulenartigen Vorsprungs ein lichtstarkes Lichtquellen-Cluster, insbesondere LED-Cluster mit hohem Output angeordnet sein, während auf der davon beabstandeten, den Vorsprung ringförmig umgebenden Lichteintrittsfläche ein Cluster von andersfarbigen Lichtquellen angeordnet sein kann, um die Farbtemperatur steuern und/oder verändern zu können.

Es sind aber auch andere Kombinationen von Lichtquellen, die in verschiedenen Ebenen bzw. an verschiedenen Lichteintrittsflächen angeordnet sein können, möglich. Beispielsweise können Lichtquellen mit sichtbaren Spektren und Lichtquellen mit nicht sichtbaren Spektren durch den Lichtmischstab gemischt werden bzw. an verschiedenen Lichteintrittsflächen angeordnet sein. Beispielsweise können an einer Lichteintrittsfläche zumindest eine Infrarotlichtquelle angeordnet sein und an einer weiteren Lichtfläche zumindest eine Fluoreszenz-Lichtquelle vorgesehen sein oder an einer anderen weiteren Lichteintrittsfläche zumindest eine Weißlicht-Lichtquelle vorgesehen sein.

Der besagte, längliche Lichtmischstab kann insgesamt schlank ausgebildet sein und eine Länge besitzen, die ein Vielfaches des Stabdurchmessers beträgt, beispielsweise mehr als das Dreifache oder mehr als das Fünffache des Stabdurchmessers.

Der Lichtmischstab kann hiervon unabhängig verschiedene Querschnittskonturierungen besitzen, beispielsweise eine von der Kreisform abweichende, insbesondere mehreckige Querschnittskonturierung besitzen, beispielsweise quadratisch ausgebildet sein.

Dem Lichtmischstab kann ein weiteres Optikelement nachgeordnet sein, beispielsweise ein bündelndes Optikelement.

Um Effizienzverluste am Übergang vom Lichtmischstab zum nachgeordneten Optikelement zu vermeiden, kann die Lichtaustrittsfläche des Lichtmischstabs deckungsgleich mit der Lichteintrittsfläche des nachgeordneten Optikelements ausgebildet sein, um das Licht über den vollen Stabquerschnitt in den vollen Eintrittsquerschnitt des Optikelements geben zu können.

Das nachgeordnete Optikelement kann direkt an den Mischstab angesetzt sein, wobei vorteilhafterweise eine direkte, spaltfreie, flächige Verbindung der Lichteintrittsfläche des Optikelements mit der Lichtaustrittsfläche des Lichtmischstabs vorgesehen sein kann, um eine hohe Effizienz zu erzielen.

Eine solche optisch dichte Verbindung kann beispielsweise durch ein integral einstückiges, materialhomogenes Anformen des Lichtmischstabs an das Optikelement erzielt werden, beispielsweise einstückig aus Glas oder transparentem Kunststoff oder Silikon. Eine optisch dichte Verbindung kann aber auch durch ein vorzugsweise vollflächiges Verkleben der Lichtaustrittsfläche des Mischstabs mit der Eintrittsfläche des Optikelements durch einen optisch transparenten Kleber erzielt werden.

Der Mischstab kann als Vollmaterialstab ausgebildet sein, wobei auf der Außenmantelfläche des aus transparentem Vollmaterial bestehenden Mischstabs ggf. eine reflektierende Beschichtung aufgebracht sein kann, sodass die in den Mischstab eingekoppelten Lichtstrahlen an der Außenmantelfläche des Mischstabs total reflektiert oder reflektiert werden können.

Grundsätzlich muss der Lichtmischstab aber kein Vollmaterialstab sein, sondern es kann auch ein hohler Stab vorgesehen sein, dessen Innenmantelfläche reflektierend ausgebildet sein kann.

Die Erfindung wird nachfolgend anhand bevorzugter Ausführungsbeispiele und zugehörigen Zeichnungen näher erläutert. In den Zeichnungen zeigen:
- Fig. 1:: eine perspektivische Ansicht einer Leuchte nach einem vorteilhaften Ausführungsbeispiel der Erfindung, die den Lichtmischstab der Mischoptik mit mehreren, axial voneinander beabstandeten Lichteintrittsflächen sowie eine dem Mischstab nachgeordnete Optik zeigt,
- Fig. 2:: eine ausschnittsweise, vergrößerte perspektivische Ansicht des Lichteintrittsendes des Mischstabs mit einem säulenartigen Vorsprung und verschiedenen LED-Clustern an den beiden Lichteintrittsflächen des Mischstabs,
- Fig. 3:: eine Seitenansicht der Mischoptik der Leuchte aus Fig. 1,
- Fig. 4:: eine Explosionsdarstellung der Leuchte aus den vorhergehenden Figuren, die den säulenartigen Vorsprung an der Lichteintrittsseite des Mischstabs und die beiden Lichtquellen-Cluster zeigt,
- Fig. 5:: eine perspektivische Explosionsdarstellung ähnlich Fig. 4, wobei die dem säulenartigen Vorsprung zugeordnete Lichtquelle vergrößert dargestellt ist,
- Fig. 6:: eine perspektivische Explosionsdarstellung ähnlich den Figuren 4 und 5, wobei die der ringförmigen Lichteintrittsfläche zugeordnete Lichtquellenanordnung vergrößert dargestellt ist,
- Fig. 7:: eine weitere Explosionsdarstellung eines Lichtmischstabs und den zugeordneten Lichtquellen gemäß einer weiteren Ausführung der Erfindung, wobei der Lichtmischstab an seinen umfangsseitigen Randabschnitten vier säulenartige Vorsprünge aufweist, denen jeweils eine Lichtquellenanordnung zugeordnet ist, wobei eine weitere Lichtquellenanordnung an der kreuzförmigen Lichteintrittsfläche zwischen den säulenartigen Vorsprüngen vorgesehen ist.

Wie die Figuren zeigen, umfasst die Leuchte 1 mehrere Lichtquellen 2, die als LEDs ausgebildet sein können. Unabhängig hiervon können die Lichtquellen 2 zu mehreren Clustern zusammengefasst sein, wobei in jedem Cluster mehrere Lichtquellen matrixartig nebeneinander angeordnet sein können.

Das von den verschiedenen Lichtquellen 2 abgegebene Licht wird dabei in einer Mischoptik 3 durchmischt, wobei die Mischoptik 3 einen länglichen Lichtmischstab 4 umfasst, an dessen Lichteintrittsende 5 die genannten Lichtquellen 2 angeordnet sind und an dessen Lichtaustrittsende 6 ein Optikelement 7 angeordnet sein kann, das je nach Leuchtentyp variieren kann. Beispielsweise kann als Optikelement 7 eine bündelnde Linse, aber auch ein Reflektor vorgesehen sein. Grundsätzlich können auch mehrere Optikelemente hintereinander oder miteinander kombiniert vorgesehen sein.

Der genannte Lichtmischstab 4 kann an das Optikelement 7 integral einstückig, materialhomogen angegossen sein. Alternativ kann das Optikelement 7 aber auch separat ausgebildet und beispielsweise durch einen optisch transparenten Klebstoff an die Lichtaustrittsfläche des Lichtmischstabs 4 optisch dicht angebunden werden.

Unabhängig hiervon kann der Lichtmischstab 4 hinsichtlich seiner Querschnittskonturierung unterschiedlich ausgebildet sein, wobei der Lichtmischstab 4 beispielsweise von der Kreisform abweichend konturiert sein kann, andererseits aber durchaus auch kreiszylindrisch ausgebildet sein kann. Wie die Figuren zeigen, kann der Lichtmischstab beispielsweise eine mehreckige, insbesondere quadratische Zylinderform nach Art eines Kantprofils bzw. eines Strangpressprofils besitzen.

Das Lichteintrittsende 5 des Lichtmischstabs 4 ist dabei nicht durchgängig gerade abgelenkt, sondern terrassenförmig abgestuft ausgebildet, sodass die Lichteintrittsfläche des Lichtmischstabs 4 in mehrere, separate Lichteintrittsflächen 8 unterteilt ist, die in Längsrichtung des Mischstabs 4 voneinander beabstandet sind. Gleichzeitig sind die Lichteintrittsflächen 8 dabei durch die stufenförmige Terrassierung des Lichteintrittsendes auch querversetzt zueinander angeordnet.

Betrachtet man den Lichtmischstab 4 mit einer Blickrichtung parallel zur Stablängsachse 9, können sich die Lichteintrittsflächen 8 nach Art von Puzzleteilen spaltfrei und überdeckungsfrei zu einer Gesamtfläche ergänzen, die der Querschnittsfläche des gesamten Lichtmischstabs 4 entsprechen kann. Insbesondere können die sich puzzleartig ergänzenden Lichteintrittsflächen 8 in ihrer Gesamtheit betrachtet kongruent zu der Querschnittsfläche des Lichtmischstabs 4 in einem Mittelabschnitt 4m sein, der an den terrassierten Lichteintritts-Endabschnitt 6 angrenzt.

Der genannte Lichtmischstab 4 kann von den genannten Abstufungen am Lichteintrittsende 5 abgesehen über seine Länge eine gleichbleibende Querschnittskonturierung und -bemaßung haben, wobei alternativ aber auch eine sich leicht verjüngende oder dicker werdende Konturierung des Mischstabs möglich ist.

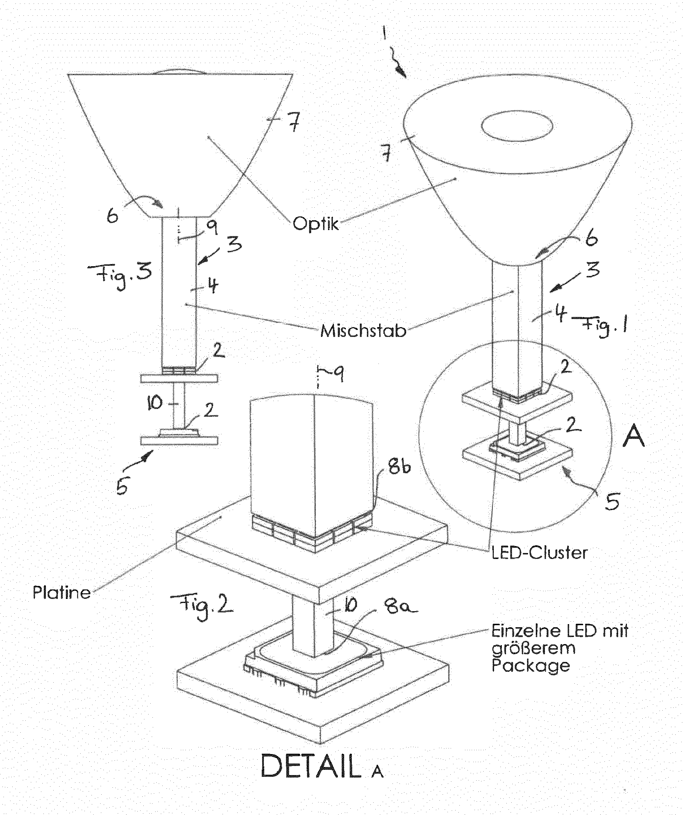

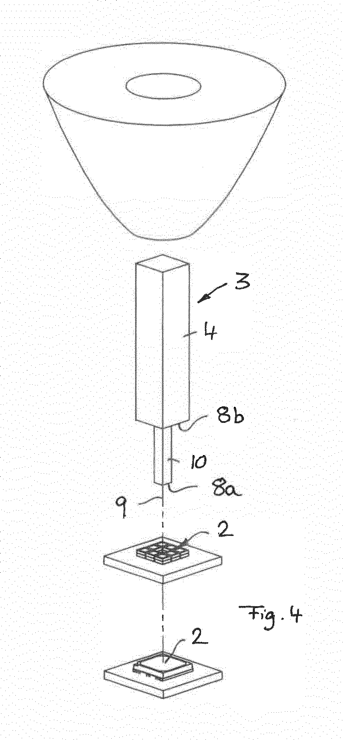

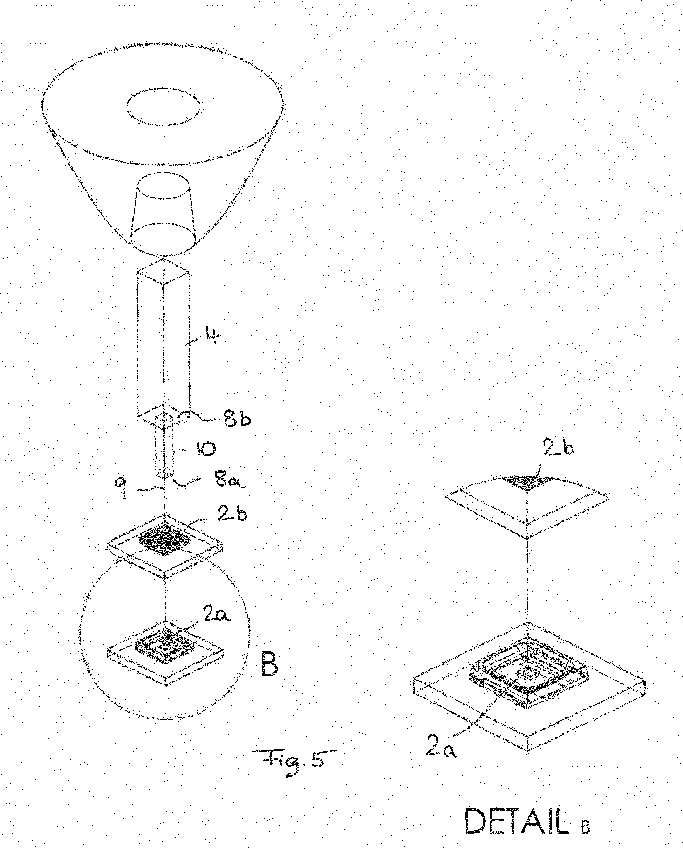

Wie die Figuren 1 bis 6 zeigen, kann beispielsweise am Lichteintrittsende 5 des Lichtmischstabs 4 ein im Querschnitt verjüngter, säulenartiger Vorsprung 10 vorgesehen sein, der zum Lichteintrittsende hin vorspringt und sich parallel zur Stablängsachse 9 erstrecken kann. Der besagte säulenartige Vorsprung 10 kann beispielsweise zentral in der Mitte des Mischstabquerschnitts angeordnet sein, wobei aber auch exzentrische Positionen des Vorsprungs 10 möglich sind.

Eine der genannte Lichteintrittsflächen 8a kann vom stirnseitigen Ende des säulenartigen Vorsprungs 10 gebildet sein, während eine andere Lichteintrittsfläche 8 den Wurzelbereich des Vorsprungs 10 ringförmig umgeben kann. Gemäß dem gezeigten Ausführungsbeispiel der Figuren 1 bis 6 kann die genannte zweite Lichteintrittsfläche 8b rechteckig konturiert sein und ein zentrales Loch aufweisen, aus dem der säulenartige Vorsprung 10 herauswächst, wobei die stirnseitige Endfläche des Vorsprungs 10, das heißt die erste Lichteintrittsfläche 8a bei Betrachtung des Mischstabs 4 in Richtung der Stablängsachse 9 das besagte Loch in der zweiten Lichteintrittsfläche 8m ausfüllen kann. Je nach Position des säulenartigen Vorsprungs 10, beispielsweise in der Mitte oder am Rand der den Mischstab umgebenden Hüllfläche, kann die genannte zweite Lichteintrittsfläche 8b, die den säulenartigen Vorsprung 10 an dessen Wurzelbereich umgibt, einen Vollring oder einen Teilring nach Art eines Halb- oder Dreiviertelmonds bilden.

Wenn der säulenartige Vorsprung 10 sich über seine Länge verjüngt oder im Querschnitt aufweitet oder im Querschnitt verändert, kann die genannte erste Lichteintrittsfläche 8a aber auch von der Konturierung des Lochs bzw. der Aussparung der zweiten Lichteintrittsfläche 8b abweichen.

Wie die Figuren zeigen, sitzen auf jeder der Lichteintrittsflächen 8a und 8b Lichtquellen 2, vorzugsweise jeweils mehrere clusterartig angeordnete Lichtquellen 2, die hinsichtlich ihrer Lichtfarbe und/oder ihres Spektrums und/oder ihrer Leistung und/oder ihrer Größe voneinander abweichen können. Beispielsweise können an einer der Lichteintrittsflächen 8 Lichtquellen 2 mit einem unsichtbaren Spektrum und an einer anderen Lichteintrittsfläche 8 Lichtquellen mit einem sichtbaren Spektrum vorgesehen sein.

Beispielsweise können Infrarotlichtquellen an einer Lichteintrittsfläche und Fluoreszenz-Lichtquellen an einer anderen Lichteintrittsfläche und Lichtquellen mit sichtbaren Licht an einer wiederum anderen Lichteintrittsfläche vorgesehen sein, wobei aber auch, wie eingangs erläutert, andere Lichtquellen-Kombinationen vorgesehen sein können.

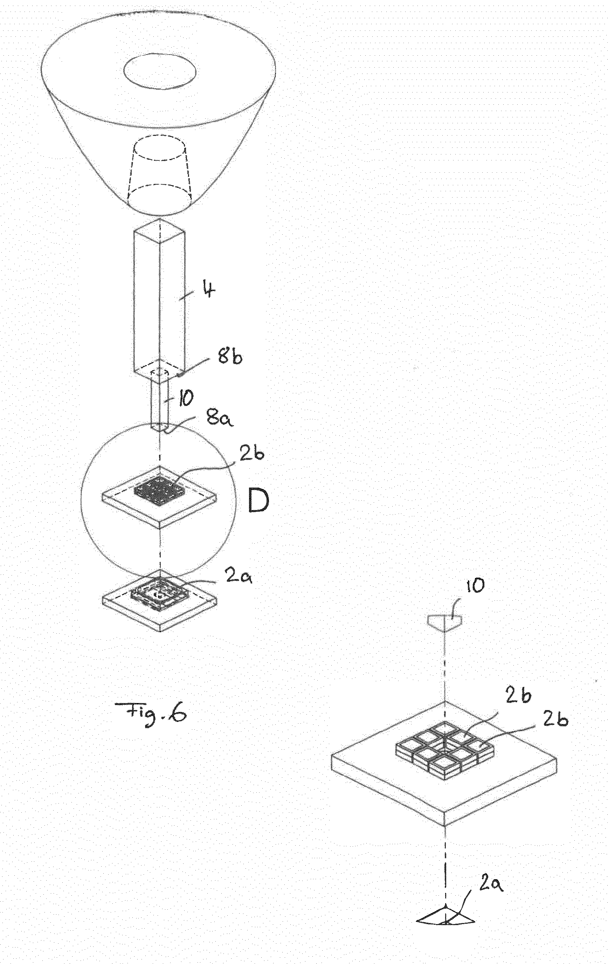

Ist am Lichteintrittsende 5 des Lichtmischstabs 4 ein säulenartiger Vorsprung 10 vorgesehen, wie dies die Figuren 1 bis 6 zeigen, kann an der zweiten Lichteintrittsfläche 8b ein ringförmiges Lichtquellen-Cluster vorgesehen sein, das um den Vorsprung 10 herum verteilt angeordnete Lichtquellen umfasst, vgl. Figur 6.

An der ersten Lichteintrittsfläche 8a am Ende des säulenartigen Vorsprungs 10 kann beispielsweise eine einzelne Lichtquelle 2 mit einem größeren lichttechnisch inaktiven Abschnitt, beispielweise eine einzelne LED mit einem größeren Package vorgesehen sein, das ohne Probleme randseitig über den Querschnitt des säulenförmigen Vorsprungs überstehen kann, vgl. beispielsweise Figur 2.

Auch das Cluster der Lichtquellen 2 an der zweiten Lichteintrittsfläche 8 kann mit lichttechnisch inaktiven Randabschnitten, beispielsweise den die Chips tragenden Packages der LEDs seitlich überstehen, ohne dass dies zu Kollisionsproblemen führen würde.

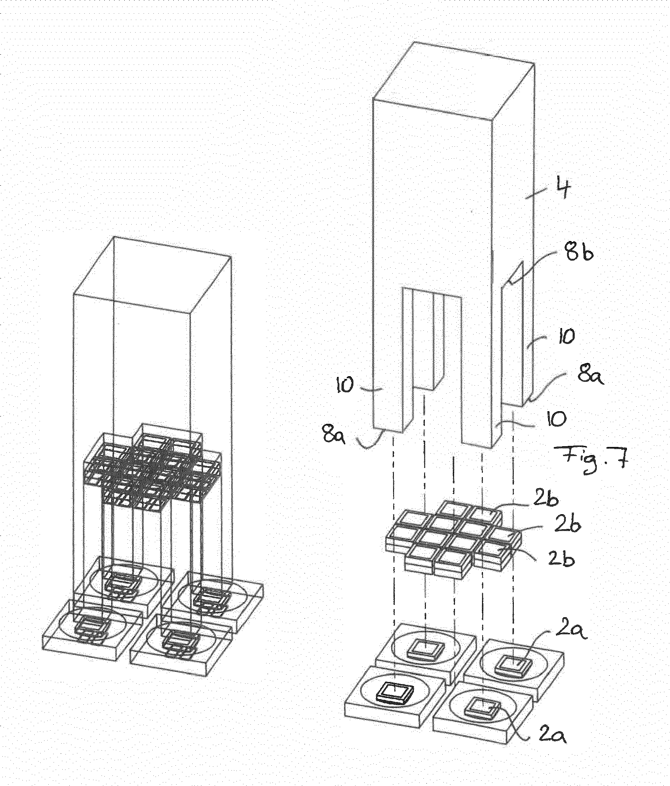

Wie Figur 7 zeigt, können am Lichteintrittsende 5 des Lichtmischstabs 4 aber auch mehrere säulenartige Vorsprünge 10 vorgesehen sein, die beispielsweise bündig mit der Umfangsfläche des anschließenden Mittelabschnitts 4m des Lichtmischstabs 4 angeordnet sein können, beispielsweise an den Ecken bzw. Kanten des Lichtmischstabs 4, vgl. Figur 7.

Im Wurzelbereich der säulenartigen Vorsprünge 10 kann eine kreuzförmige oder sternförmige Lichteintrittsfläche 8b vorgesehen sein, an der ein entsprechend konturiertes Lichtquellen-Cluster, beispielsweise ein kreuz- oder sternförmiges LED-Cluster, angeordnet werden kann, um in die genannte Lichteintrittsfläche 8b Licht einzukoppeln.

An den stirnseitigen Enden der säulenartigen Vorsprünge 10 können einzelne Lichtquellen oder ggf. Lichtquellen-Cluster angeordnet sein, wobei an allen säulenartigen Vorsprüngen 10 Lichtquellen desselben Typs und/oder derselben Bemaßung, aber vorteilhafterweise auch unterschiedlich ausgebildete Lichtquellen 2 vorgesehen sein können, beispielsweise Lichtquellen verschiedener Lichtfarbe und/oder verschiedener Leistung und/oder verschiedener Spektren und/oder verschiedener Packagegröße.

## Patentansprüche

1. Leuchte mit mehreren Lichtquellen (2) sowie einer Mischoptik (3) zum Durchmischen des von den Lichtquellen (2) abgegebenen Lichts, die zumindest einen Lichtmischstab (4) aufweist, der mehrere Lichteintrittsflächen (8) aufweist, die in Längsrichtung des Lichtmischstabs (5) voneinander beabstandet angeordnet sind, wobei die mehreren Lichtquellen (2) auf die mehreren Lichteintrittsflächen (8) verteilt und in Längsrichtung des Lichtmischstabs (5) zueinander versetzt angeordnet sind, **dadurch gekennzeichnet, dass** der Lichtmischstab (4) an seinem Lichteintrittsende (5) zumindest einen säulenartigen Vorsprung (10) besitzt, der eine kleinere Querschnittsfläche als ein Mittelabschnitt (4m) des Mischstabs besitzt und mit seinem stirnseitigen Ende eine der Lichteintrittsflächen (8a) bildet, wobei sich am Wurzelbereich des säulenartigen Vorsprungs (10) zumindest eine zweite Lichteintrittsfläche (8b) spaltfrei und/oder bündig anschließt.

2. Leuchte nach dem vorhergehenden Anspruch, wobei der Lichtmischstab (4) an seinem Lichteintrittsende (5) terrassenartig abgestuft ausgebildet ist, wobei die terrassenartigen Abstufungen mit ihren stirnseitigen Endflächen jeweils eine der genannten Lichteintrittsflächen (8) bilden, wobei die terrassenartigen Abstufungen vorzugsweise integral einstückig, materialhomogen mit einem Mittelabschnitt (4m) des Lichtmischstabs (4) verbunden, insbesondere daran angeformt sind.

3. Leuchte nach dem vorhergehenden Anspruch, wobei der säulenartige Vorsprung (10) sich parallel zur Längsachse (9) des Lichtmischstabs (4) und innerhalb einer den Mittelabschnitt (4m) des Lichtmischstabs (4) umgebenden und zum Lichteintrittsende (5) hin verlängerten Hüllfläche erstreckt, wobei der säulenartige Vorsprung (10) einen über seine Länge zumindest näherungsweise gleichbleibenden Querschnitt besitzt.

4. Leuchte nach einem der vorhergehenden Ansprüche, wobei der säulenartige Vorsprung eine/n Durchmesser/Dicke im Bereich von 10% bis 75% oder 20% bis 50% des/der Durchmessers/Dicke des Mittelabschnitts des Lichtmischstabs aufweist.

5. Leuchte nach einem der vorhergehenden Ansprüche, wobei der säulenartige Vorsprung einen von der Kreisform abweichenden oder eckigen Querschnitt besitzt.

6. Leuchte nach einem der vorhergehenden Ansprüche, wobei die genannte zweite Lichteintrittsfläche (8b) am Wurzelbereich des säulenartigen Vorsprungs (10) den säulenartigen Vorsprung ringförmig umgibt, wobei auf der genannten ringförmigen zweiten Lichteintrittsfläche (8b) um den säulenartigen Vorsprung (10) herum eine oder mehrere Lichtquellen (2) angeordnet sind.

7. Leuchte nach einem der vorhergehenden Ansprüche, wobei der zumindest eine oder ein weiterer säulenartiger Vorsprung (10) in seinem Wurzelbereich an eine Umfangsfläche des Mittelabschnitts (4m) des Lichtmischstabs (4) bündig anschließt und dort nur teilweise von einer Lichteintrittsfläche (8b) umgeben ist.

8. Leuchte nach einem der vorhergehenden Ansprüche, wobei mehrere, quer zur Stablängsachse (9) voneinander beabstandete säulenartige Vorsprünge (10) vorgesehen sind, zwischen deren Wurzelbereiche eine vorzugsweise kreuz- oder sternförmige Lichteintrittsfläche (8b) vorgesehen ist.

9. Leuchte nach einem der vorhergehenden Ansprüche, wobei mehrere, voneinander beabstandete Lichteintrittsflächen (8) in einer gemeinsamen Ebene angeordnet sind, die vorzugsweise senkrecht zur Stablängsachse (9) ausgerichtet ist und/oder zumindest drei Lichteintrittsflächen (8) in zumindest drei voneinander beabstandeten Ebenen angeordnet sind, die vorzugsweise jeweils senkrecht zur Stablängsachse (9) ausgerichtet sind.

10. Leuchte nach einem der vorhergehenden Ansprüche, wobei bei Betrachtung des Lichtmischstabs (4) in einer Blickrichtung parallel zur Stablängsachse (9), sich die Lichteintrittsflächen (8) spalt- und überlappungsfrei zu einer Gesamtfläche ergänzen, die kongruent zur Querschnittsfläche eines Mittelabschnitts des Lichtmischstabs (4), der an das Lichteintrittsende (5) angrenzt, ausgebildet ist.

11. Leuchte nach einem der vorhergehenden Ansprüche, wobei bei Betrachtung des Lichtmischstabs (4) in einer Blickrichtung parallel zur Stablängsachse (9) sich die Lichtquellen (2) mit lichttechnisch nicht aktiven Abschnitten überdecken und/oder zumindest eine Lichtquelle (2) mit einem lichttechnisch nicht aktiven Abschnitt einen lichttechnisch aktiven Abschnitt einer anderen Lichtquelle (2) überdeckt und/oder auf dem zumindest einen säulenartigen Vorsprung (10) eine Lichtquelle (2) angeordnet ist, die mit einem lichttechnisch nicht aktiven Abschnitt quer über den säulenartigen Vorsprung (10) vorspringt und in Richtung der Stablängsachse (9) eine andere Lichtquelle (2) überlappt.

12. Leuchte nach einem der vorhergehenden Ansprüche, wobei an den verschiedenen Lichteintrittsflächen (8) Lichtquellen (2) verschiedener Lichtfarbe und/oder verschiedener Spektren und/oder verschiedener Leistungen und/oder verschiedener Abmessungen vorgesehen sind.

13. Leuchte nach dem vorhergehenden Anspruch, wobei an zumindest einer Lichteintrittsfläche (8) zumindest eine Lichtquelle (2) mit einem nicht sichtbaren Spektrum und an zumindest einer anderen Lichteintrittsfläche (8) zumindest eine Lichtquelle (2) mit einem sichtbaren Spektrum angeordnet ist.

14. Leuchte nach einem der vorhergehenden Ansprüche, wobei an zumindest einer Lichteintrittsfläche (8b) ein Cluster von Lichtquellen (2) kleinerer Abmessungen und an zumindest einer weiteren Lichteintrittsfläche (8a), insbesondere an einem säulenartigen Vorsprung (10), zumindest eine Lichtquelle (2) größerer Abmessung vorgesehen ist.

15. Leuchte nach einem der vorhergehenden Ansprüche, wobei alle oder mehrere Lichteintrittsflächen (8) zumindest näherungsweise eben ausgebildet sind und zumindest näherungsweise senkrecht zur Längsrichtung des Lichtmischstabs (5) ausgerichtet sind.
